# EUROPÄISCHE PATENTSCHRIFT

(11) **EP 2 436 057 B1**
(45) Veröffentlichungstag und Bekanntmachung des Hinweises auf die Patenterteilung: **02.10.2013**
(21) Anmeldenummer: 10722096.4
(22) Anmeldetag: 28.05.2010
(51) Int. Cl.: H01L 51/10, H01L 51/44, H01L 51/52

(54) **ELEKTRONISCHES BAUELEMENT UND VERFAHREN ZUR HERSTELLUNG EINES ELEKTRONISCHEN BAUELEMENTS**
ELECTRONIC COMPONENT AND METHOD FOR PRODUCING AN ELECTRONIC COMPONENT
COMPOSANT ÉLECTRONIQUE ET PROCÉDÉ DE PRODUCTION

(30) Priorität: 29.05.2009 DE 102009023350
(43) Veröffentlichungstag der Anmeldung: 04.04.2012
(73) Patentinhaber: OSRAM Opto Semiconductors GmbH, 93055 Regensburg (DE); Siemens Aktiengesellschaft, 80333 München (DE)
(72) Erfinder: SCHMID, Günther, 91334 Hemhofen (DE); HUNZE, Arvid, 91056 Erlangen (DE)
(74) Vertreter: Epping - Hermann - Fischer
(86) Internationale Anmeldenummer: PCT/EP2010/057482
(87) Internationale Veröffentlichungsnummer: WO 2010/136591

(56) Entgegenhaltungen:
- US-A1- 2007 273 280
- US-A1- 2008 163 926

## Beschreibung

Die Erfindung betrifft ein elektronisches Bauelement und ein Verfahren zur Herstellung eines elektronischen Bauelements.

Die Lebensdauer von elektronischen Bauelementen hängt unter anderem von ihrer Abschirmung gegenüber Luftsauerstoff und Feuchtigkeit ab, da sie oft reaktive Materialien, beispielsweise korrosionsanfällige Metalle, oder hygroskopische Schichten enthalten. Beispielsweise können elektronisch angeregte organische Moleküle beim Betrieb eines elektronischen Bauelements leicht mit Sauerstoff oder Wasser reagieren, was deren Lebensdauer begrenzt.

Das Dokument US 2008/163926 A1 beschreibt eine organische Solarzelle, die von mindestens einer Polymerschicht und mindestens einer Metallschicht umgeben ist.

Das Dokument US 2007/273280 A1 beschreibt ein Licht emittierendes Bauelement mit mindestens einer Metalloxid-, Metallnitrid- oder Metalloxynitridschicht und mindestens einer Polymerschicht.

Eine zu lösende Aufgabe besteht darin, ein elektronisches Bauelement bereitzustellen, das eine verbesserte Abschirmung aufweist. Diese Aufgabe wird durch ein elektronisches Bauele ment gemäß dem Patentanspruch 1 gelöst. Weitere Ausführungsformen des Bauelements und ein Verfahren zur Herstellung eines elektronischen Bauelements, das eine verbesserte Abschirmung aufweist, sind Gegenstand weiterer Patentansprüche.

Gemäß einer Ausführungsform wird ein elektronisches Bauelement bereitgestellt, das ein Substrat, eine Schichtenfolge, die zumindest eine Funktionsschicht umfasst, auf dem Substrat, und eine Verkapselung, die auf der Schichtenfolge und dem Substrat angeordnet ist und zusammen mit dem Substrat die Schichtenfolge vollständig umschließt, bereitgestellt. Dabei weist die Verkapselung zumindest zwei Doppelschichten auf, wobei eine Doppelschicht eine erste Schicht und eine zweite Schicht aufweist, und die erste Schicht eine organische monomolekulare Schicht mit einer zweidimensionalen Ordnung ist. Diese zweidimensionale Ordnung kann amorph sein.

Es wird also ein Schichtsystem aus Doppelschichten, die jeweils eine erste und eine zweite Schicht umfassen, bereitgestellt, wobei die ersten und zweiten Schichten abwechselnd übereinander angeordnet sind, so dass eine dichte Verkapselung hergestellt wird. Die äußersten Schichten der Verkapselung können entweder erste oder zweite Schichten sein, das heißt, die an die Schichtenfolge angrenzende Schicht der Verkapselung kann eine erste oder eine zweite Schicht sein und die von der Schichtenfolge am weitesten entfernte Schicht der Verkapselung kann eine erste oder eine zweite Schicht der Verkapselung sein. Die Verkapselung schirmt die Schichtenfolge, die zumindest eine Funktionsschicht enthält, vor Luftsauerstoff und Feuchtigkeit ab, so dass Schichten in der Schichtenfolge, die empfindlich auf Luftsauerstoff und/oder Feuchtigkeit reagieren, geschützt werden. Dadurch wird die Lebensdauer dieser Schichten und damit auch des elektronischen Bauelements verlängert.

Die erste Schicht kann lineare Moleküle mit einer Länge, die aus dem Bereich 0,5 nm bis 5 nm ausgewählt ist, umfassen und eine Dicke aufweisen, die der Länge der linearen Moleküle entspricht. Damit wird eine erste Schicht einer Doppelschicht der Verkapselung bereitgestellt, die eine Dicke von 0,5 nm bis 5 nm aufweisen kann, beispielsweise kann die Dicke der ersten Schicht zwischen 1 und 3 nm betragen.

Die linearen Moleküle können eine erste Endgruppe, eine Mittelgruppe und eine zweite Endgruppe umfassen. Die erste Endgruppe kann beispielsweise eine Ankergruppe sein und die zweite Endgruppe kann beispielsweise eine Kopfgruppe sein. Durch geeignete Wahl der ersten und der zweiten Endgruppe, kann die erste Schicht gut an die zweite Schicht beziehungsweise an die zweite Schicht einer weiteren Doppelschicht angekoppelt werden. Weiterhin führt eine geeignete Wahl der ersten und zweiten Endgruppen zu einer guten Ankopplung der jeweiligen Endgruppen unter sich, so dass die erste Schicht eine hohe Dichte und damit chemische und thermische Stabilität aufweist.

Solche linearen Moleküle, die an einem Ende eine erste Endgruppe aufweisen, können auf Oberflächen dünne, monomolekulare Schichten (self-assembling monolayers: SAM) ausbilden. Die monomolekularen Schichten können auch selbst organisierende Monolagen genannt werden.

Eine erste Schicht, die aus den oben beschriebenen linearen Molekülen gebildet ist, kann mit der zweiten Schicht beispielsweise kovalente Bindungen ausbilden und daher eine gute Haftung auf der Oberfläche der zweiten Schicht aufweisen. Die Bindung an die Oberfläche der zweiten Schicht kann spontan und gerichtet erfolgen. Dadurch entsteht eine zweidimensionale Ordnung in der organischen monomolekularen Schicht, womit besonders dichte erste Schichten erzeugt werden können. So können beispielsweise sehr dünne Dielektrika hergestellt werden, die keine oder wenige Leckstrompfade aufweisen, was durch hohe Durchbruchspannungen gezeigt werden kann. Dadurch sind die monomolekularen Schichten auch undurchlässig oder kaum durchlässig für größere Moleküle, beispielsweise Wasser oder Sauerstoff. Fehlstellen, wie beispielsweise Pinholes, in der zweiten Schicht, die eine Größe von weniger als 10 nm aufweisen, können durch die linearen Moleküle der ersten Schicht geschlossen werden. Dadurch, dass die erste Schicht eine monomolekulare Schicht umfasst, kann die Gesamtdicke der Verkapselung sehr gering ausgestaltet werden, womit sowohl Material- als auch Prozesskosten eingespart werden können.

Die Mittelgruppe der linearen Moleküle kann eine Molekülkette sein und aus einer Gruppe ausgewählt sein, die lineare Alkyle, lineare fluorierte Alkyle, Polyethylenglykol und Polyethylendiamin umfasst. Die Mittelgruppen können die elektrischen Eigenschaften der ersten Schicht beeinflussen, indem je nach Bedarf isolierende aliphatische Systeme oder elektrisch leitende konjugierte Doppelbindungen als Mittelgruppe gewählt werden.

Lineare Alkyle können 2 bis 20 Kohlenstoffatome aufweisen, beispielsweise 10 bis 18 Kohlenstoffatome. Auch lineare fluorierte Alkyle können 2 bis 20, beispielsweise 10 bis 18 Kohlenstoffatome aufweisen. Beispielsweise können lineare Alkyle mit 2 bis 20 Kohlenstoffatomen als zweite Endgruppe Arylgruppen aufweisen, die durch die Ausbildung von pi-pi-Wechselwirkungen die linearen Moleküle untereinander und in Bezug auf die angrenzende zweite Schicht stabilisieren. Die Arylgruppen können substituiert oder unsubstituiert sein. Substituenten können fluorierte und/oder ungesättigte Alkylgruppen, Halogene oder S-, N- oder P-haltige Verbindungen sein. Zur Herstellung einer ersten Schicht können auch verschiedene lineare Moleküle verwendet werden.

Die erste Endgruppe kann aus einer Gruppe ausgewählt sein, die Hydroxamsäuren, Oxime, Isonitrile, Phosphine, R₁-Si (R₂) - R₃, O=C-R₄, O=P(R₅)-R₆ und O=S(R₇)=O umfassen. Dabei sind R₁, R₂, R₃ - unabhängig voneinander - ausgewählt aus H, Cl, Br, I, OH, 0-Alkylgruppen, Benzylgruppen und ungesättigten Alkenylgruppen, wobei mindestens eines aus R₁, R₂ und R₃ nicht H ist. Weiterhin kann R₄ ausgewählt sein aus H, Cl, Br, I, OH, OSiR₁R₂R₃, 0-Alkylgruppen, Benzylgruppen und ungesättigten Alkenylgruppen. R₅ und R₆ können - unabhängig voneinander - ausgewählt sein aus H, Cl, Br, I, OH, O-Alkylgruppen, Benzylgruppen und ungesättigten Alkenylgruppen. Weiterhin kann R₇ ausgewählt sein aus Cl, Br, I, OH, O-Alkylgruppen, Benzylgruppen und ungesättigten Alkenylgruppen.

Beispielhafte lineare Moleküle der ersten Schicht, die die oben genannten Eigenschaften aufweisen, können gemäß Formel 1 aufgebaut sein.

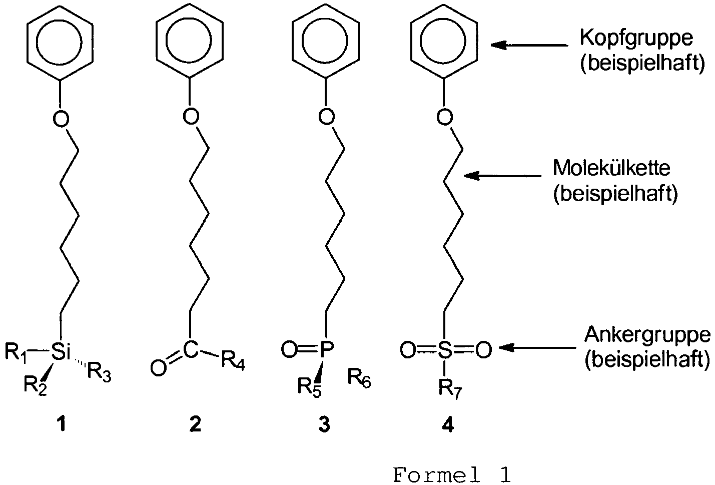

Für sämtliche R₁ bis R₇ gilt, dass Alkylgruppen beispielsweise Methyl, Ethyl, n-Propyl, i-Propyl, n-Butyl, sec-Butyl, tert-Butyl, sowie deren verzweigte und verzweigte höhere Homologen sein können. R₄ kann OSiR₁R₂R₃ mit R₁, R₂, R₃ - unabhängig voneinander - nur Alkyl oder H sein. Die erste Endgruppe O=P(R₅)-R₆ kann besonders stabile Bindungen zu der angrenzenden zweiten Schicht und/oder benachbarten ersten Endgruppen ausbilden.

Die zweite Endgruppe kann ausgewählt sein aus einer Gruppe, die die erste Endgruppe, unsubstituierte Arylgruppen, substituierte Arylgruppen, substituierte Aromaten, unsubstituierte Aromaten, substituierte Heteroaromaten und unsubstituierte Heteroaromaten umfasst. Beispielsweise kann die zweite Endgruppe Furan, Tiophen, Pyrrol, Oxazol, Thiazol, Imidazol, I-soxazol, Isothiazol, Pyrazol, Benzo[b]furan, Benzo[b]thiophen, Indol, 2H-Isoindol, Benzothiazol, Pyridin, Pyrazin, Pyrimidin, Pyrylium, α-Pyron, γ-Pyron, Chinolin, IsoChinolin, Bipyridin und die jeweiligen Derivate sein. Beispielhafte zweite Endgruppen sind in der Formel 2 gezeigt.

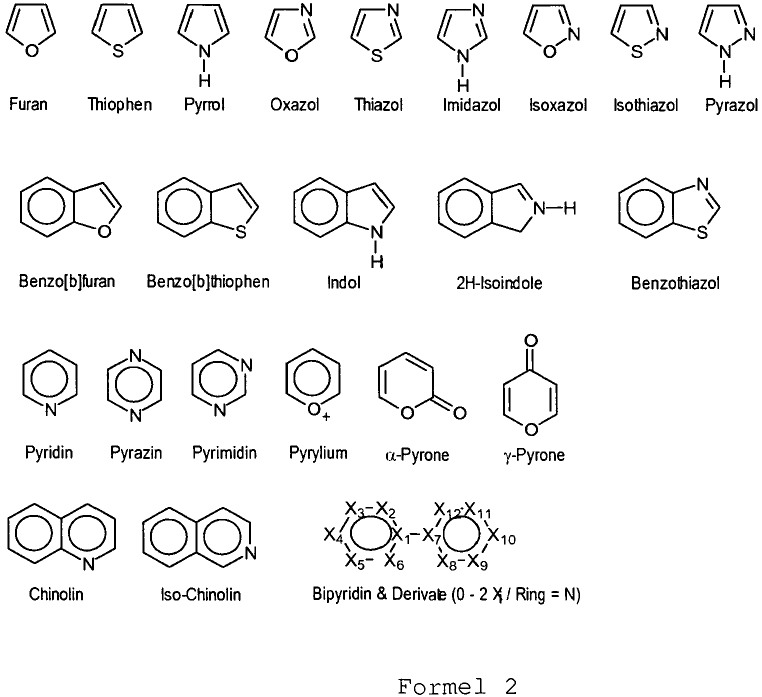

Die zweiten Endgruppen können direkt oder über die Heteroatome O, S, N, P an die Mittelgruppe angebunden sein. Auch eine Anbindung über die C-C-Doppelbindung oder C-C-Dreifachbindung ist möglich. Die zweite Endgruppe kann Substituenten aufweisen, die Bestandteile der ersten Endgruppe aufweist. Weiterhin kann die zweite Endgruppe auch eine Methylgruppe oder eine zu einer Carboxylgruppe oxidierte Methylgruppe sein. Damit kann eine angrenzende zweite Schicht gut an die erste Schicht angebunden werden.

Die zweite Schicht kann ein Material aufweisen, das aus einer Gruppe ausgewählt ist, die Metalle, Metalllegierungen, Metalloxide und Polymere umfasst. Metalle können beispielsweise nicht reaktive oder sich selbst passivierende Metalle oder Metalllegierungen sein, zum Beispiel Al, Cr, Ni, Fe, Ag, Edelstahl, AlMg₃ und weitere Aluminiumlegierungen. Metalloxide können beispielsweise aus SiO₂ oder Al₂O₃ sowie aus Indiumzinnoxid (ITO) oder Zinkoxid ausgewählt sein, die durch bekannte Verfahren abgeschieden werden können. Polymere können beispielsweise Parylene, Acrylate oder Novolacke sein. Bei der Verwendung von Polymeren als zweite Schicht sollte auf der Oberfläche der zweiten Schicht eine hohe OH-Gruppendichte vorhanden sein, damit eine stabile Verbindung zu der angrenzenden ersten Schicht ausgebildet werden kann. Eine hohe OH-Dichte kann beispielsweise mit einer OH-Gruppe an mindestens jeder zehnten Monomereinheit realisiert werden. Beispielsweise weisen Poly-o-hydroxy-styrol oder Polyvinylalkohol eine hohe OH-Dichte auf. Wenn mehrere Doppelschichten mit jeweils einer zweiten Schicht auf der Schichtenfolge und dem Substrat angeordnet sind, können für die einzelnen zweiten Schichten auch verschiedene Materialien ausgewählt sein.

Die zweite Schicht kann eine Dicke aufweisen, die aus dem Bereich 5 nm bis 1 µm ausgewählt ist. Beispielsweise kann die Dicke aus einem Bereich von 50 nm bis 1 µm ausgewählt sein. Je dicker die Dicke der zweiten Schicht gewählt wird, desto dichter ist die zweite Schicht. Es kann somit auch eine hermetisch dichte zweite Schicht bereitgestellt werden.

Wird die zweite Schicht als Metallschicht ausgeführt, kann diese Pinholes aufweisen, die sich durch eine weitere Abscheidung von Metallatomen nicht schließen lassen, da Pinholes durch die neu abgeschiedenen Metallatome nicht benetzt werden. Die Abscheidung einer ersten Schicht kann dann dazu führen, dass die Oberflächenenergie zurückgesetzt wird, wenn das Metall auf der ersten Schicht schlechter benetzt als auf den Metallatomen. Somit wird das Pinhole zuerst mit Material der ersten Schicht und dann mit weiteren Metallatomen verschlossen und insgesamt eine dünne, dichte Schichtenfolge erzeugt.

Insgesamt wird eine Doppelschicht mit einer geringen Dicke bereitgestellt, da sowohl die erste als auch die zweite Schicht als dünne Schichten ausgeführt werden können. Somit wird eine dichte Dünnfilmverkapselung des elektronischen Bauelements bereitgestellt. Die Dünnfilmverkapselung kann dabei bis zu 30 Doppelschichten aufweisen.

Zwischen der zweiten Schicht und den ersten Endgruppen der ersten Schicht und/oder zwischen der zweiten Schicht und den zweiten Endgruppe der ersten Schicht können chemische Bindungen und/oder Komplexbindungen und/oder Van-der-Waals-Wechselwirkungen vorhanden sein. Somit sind zwischen den einzelnen Schichten der Doppelschichten stabile Bindungen ausgebildet, die zu einer dichten Verkapselung führen.

Die Verkapselung kann weiterhin zumindest eine dritte Schicht aufweisen, die Wasser- und Sauerstoffmoleküle bindet. Diese Bindung kann chemisch erfolgen und erhöht die Verkapselungseigenschaft der Doppelschichten. Als Material für die dritte Schicht kann beispielsweise Ca, Mg, Yb, Ba oder Sr ausgewählt werden. Die zumindest eine dritte Schicht kann zwischen den Doppelschichten angeordnet sein.

Die Schichtenfolge des elektronischen Bauelements kann ausgewählt sein aus einer Gruppe, die organische Leuchtdioden, organische magnetoresistive Bauelemente, anorganische magnetoresistive Bauelemente, elektrochrome Anzeigeelemente, organische Solarzellen, anorganische Solarzellen, organische Fotodioden, anorganische Fotodioden, organische Sensoren, anorganische Sensoren und Oberflächenwellenfilter umfasst. Magnetoresistive Bauelemente können dabei den GMR- oder TMR-Effekt zeigen. Elektrochrome Anzeigeelemente können pixeliert oder segmentiert sein. Beispielsweise können auch auf Leiterplatten aufgebondete Si-Chips, hermetisch dicht durch die oben beschriebenen Doppelschichten abgeschirmt werden.

Es wird weiterhin ein Verfahren zur Herstellung eines elektronischen Bauelements bereitgestellt. Das Verfahren umfasst die Verfahrensschritte A) Anordnen einer Schichtenfolge, die zumindest eine Funktionsschicht umfasst, auf einem Substrat, B) Anordnen einer Verkapselung mit zumindest zwei Doppelschichten auf dem Substrat und der Schichtenfolge, so dass die Schichtenfolge von dem Substrat und der Verkapselung vollständig umschlossen ist, wobei der Verfahrensschritt B) die Verfahrensschritte B1) Aufbringen einer ersten Schicht und B2) Aufbringen einer zweiten Schicht, wobei als erste Schicht eine organische monomolekulare Schicht mit einer zweidimensionalen Ordnung hergestellt wird, umfasst. Die Verfahrensschritte B1) und B2) werden dabei mindestens zweimal abwechselnd wiederholt, so dass zumindest zwei Doppelschichten, die jeweils eine erste Schicht und eine zweite Schicht umfassen hergestellt werden. Damit wird ein einfach durchzuführendes Verfahren bereitgestellt, mit dem eine Schichtenfolge, die empfindlich gegenüber Sauerstoff und/oder Feuchtigkeit ist, verkapselt wird.

Im Verfahrensschritt B2) kann ein Material für die zweite Schicht mit einer Methode aufgebracht werden, die aus einer Gruppe ausgewählt ist, die Aufdampfen, Sputtern, Drucken und stromlose Metallisierung umfasst. Als Material für die erste Schicht können Metalle, Metalllegierungen, Metalloxide und Polymere gewählt werden. Polymere können auch aus der Gasphase oder Flüssigphase aufgebracht werden, und durch ein O₂-Plasma modifiziert werden, damit an der Oberfläche eine hohe OH-Gruppendichte vorliegt.

Im Verfahrensschritt B1) kann ein Material für die erste Schicht aus der Gasphase oder aus einer Lösung aufgebracht werden. Als Material für die erste Schicht können lineare Moleküle mit einer ersten Endgruppe, einer Mittelgruppe und einer zweiten Endgruppe wie oben beschrieben eingesetzt werden.

Wird das Material für die erste Schicht im Verfahrensschritt B1) aus der Lösung aufgebracht, kann im Anschluss an den Verfahrensschritt B2) eine Temperaturbehandlung und/oder ein Belichtungsschritt vorgenommen werden, um die Bindung der ersten Schicht an die zweite Schicht zu verbessern. Anschließend wird eine Spülung durchgeführt, um überschüssiges nicht an die zweite Schicht gebundenes Material der ersten Schicht zu entfernen.

Das Material der ersten Schicht kann, wenn es in Lösung aufgebracht wird, mit einer Konzentration von 0,0001 mol/l bis 1 mol/l in einem Lösungsmittel beziehungsweise einem Lösungsmittelgemisch gelöst vorliegen. Lösungsmittel können ausgewählt sein aus einer Gruppe, die Kohlenwasserstoffe beispielsweise Pentan, Hexan, Heptan, Octan, Benzol, Toluol, Xylol, Cresol, Tetralin und Decalin, chlorierte Kohlenwasserstoffe, beispielsweise Dichlormethan, Chloroform, Tetrachlorkohlenstoff, Trichlorethylen, Chlorbenzol und Dichlorbenzol, Alkohole, beispielsweise Methanol, n-Propanol, i-Propanol und Butanol, Ether oder zyklische Ether, beispielsweise Diethylether, Diphenylether, Tetrahydroforan und Dioxan, Ester wie beispielsweise Essigsäureester, Dimethylformanid, Dimethylsulfoxid, N-Methylpyrrolidinon, γ-Butyrolacton und Cyklohexanon umfasst.

Wird das Material für die erste Schicht im Verfahrensschritt B1) aus der Gasphase aufgebracht, kann das Material der ersten Schicht verdünnt oder unverdünnt aus einem Vakuumrezepienten aufgebracht werden. Dabei kann das Material mit einem Anteil von 1% in der Gasphase vorhanden sein. Ohne Verdünndung beträgt der Anteil des Materials 100% in der Gasphase. Zur Verdünnung des Materials der ersten Schicht dienen Edelgase wie beispielsweise He, Ne, Ar, Kr oder Xe oder inerte Gase wie N₂. Für die Abscheidung können auch leichter verdampfbare Derivate der Materialien für die erste Schicht verwendet werden. Der Druck während der Abscheidung kann 10⁻⁸ mbar bis 1000 mbar, die Temperatur kann 200°C betragen. Die Abscheidung kann beispielsweise für 0,1 min bis 10 min erfolgen. Im Anschluss an die Abscheidung kann überschüssiges Material der ersten Schicht durch Abpumpen oder Heizen entfernt werden. Reaktive Silane können beispielsweise durch Einlassen von Wasser in die Gasphase fixiert werden, wobei freie Cl-Enden des Silans polymerisieren.

Im Verfahrensschritt B2) kann zwischen der ersten Schicht und der zweiten Schicht eine chemische Bindung und/oder eine Komplexbindung und/oder eine Van-der-Waals-Wechselwirkung gebildet werden. Wird auf eine erste Doppelschicht eine zweite Doppelschicht abgeschieden, kann zwischen der zweiten Schicht der ersten Doppelschicht und der ersten Schicht der zweiten Doppelschicht ebenfalls eine chemische Bindung und/oder eine Komplexbindung und/oder eine Van-der-Waals-Wechselwirkung gebildet werden.

Sollten bei der Herstellung der zweiten Schicht Fehlstellen in der zweiten Schicht entstehen, so dass die zweite Schicht in Teilbereichen vorliegt, können diese durch die darauf abgeschiedene erste Schicht der nächsten Doppelschicht geschlossen werden. Die linearen Moleküle der ersten Schicht richten sich spontan senkrecht zu der zweiten Schicht aus, so dass sich an Fehlstellen lineare Moleküle der ersten Schicht parallel zu den Teilbereichen der zweiten Schicht anordnen. Somit kann die Dichte der zweiten Schicht erhalten und eine zuverlässige Verkapselung hergestellt werden.

Die Reihenfolge der Verfahrensschritte B1) und B2) ist nicht festgelegt. Somit kann auf die im Verfahrensschritt A) angeordnete Schichtenfolge zuerst eine erste Schicht und dann eine zweite Schicht oder zuerst eine zweite Schicht und dann eine erste Schicht abgeschieden werden. Wird zuerst der Verfahrensschritt B1) durchgeführt, also zuerst eine erste Schicht auf der Schichtenfolge abgeschieden, müssen in der Schichtenfolge Gruppen, beispielsweise metallische Gruppen, vorhanden sein, die eine Anbindung der ersten Schicht auf der Schichtenfolge ermöglichen. Der innerhalb des Verfahrensschritts B) zuletzt durchgeführte Verfahrensschritt kann ebenso entweder Verfahrensschritt B1) oder B2) sein. Werden auf der Verkapselung in nachfolgenden Verfahrensschritten noch weitere Schichten oder Elemente aufgebracht, kann beispielsweise der Verfahrensschritt B) mit dem Verfahrensschritt B1), also dem Aufbringen einer ersten Schicht, beendet werden. Die erste Schicht kann in diesem Fall als Haftvermittler dienen.

Anhand der Figuren soll die Erfindung noch näher erläutert werden.

Figur 1 zeigt die schematische Seitenansicht eines elektronischen Bauelements mit Verkapselung.

Figur 2 zeigt die schematische Seitenansicht einer Doppelschicht.

Figur 3 zeigt die schematische Seitenansicht einer weiteren Doppelschicht mit Fehlstelle.

Figur 4 zeigt die Aufnahme eines Wassertropfens auf einer O-berfläche der ersten Schicht.

Figur 5 zeigt ein Diagramm mit Kontaktwinkelmessungen auf einer Oberfläche der ersten Schicht.

Figur 6 zeigt die schematische Seitenansicht einer Schichtenfolge.

Figur 7 zeigt die schematische, perspektivische Ansicht einer Schichtenfolge.

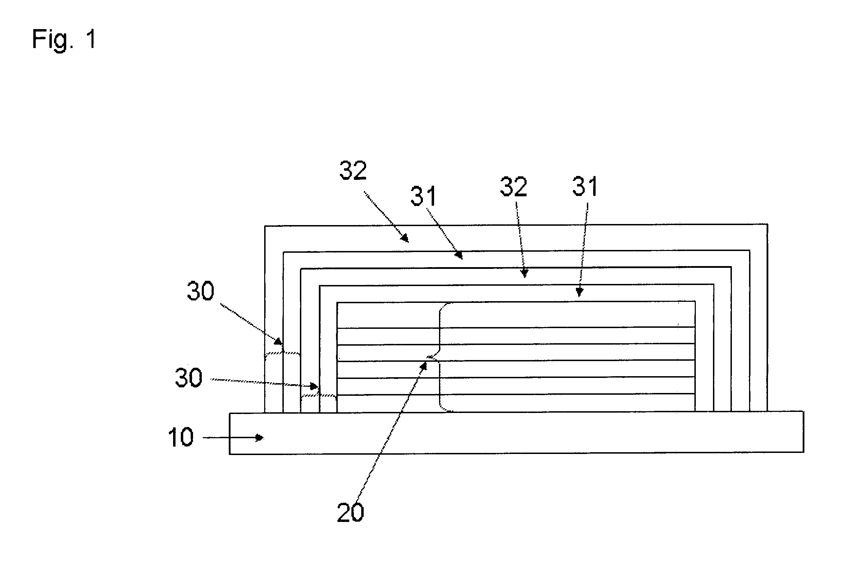

Figur 1 zeigt die schematische Seitenansicht eines elektronischen Bauelements. Auf dem Substrat 10 ist eine Schichtenfolge 20 aufgebracht. Beispielhaft wird hier eine Schichtenfolge 20 mit sechs Schichten gezeigt, wobei auch mehr oder weniger Schichten in der Schichtenfolge vorhanden sein können.

Zumindest eine Schicht in der Schichtenfolge ist eine Funktionsschicht, beispielsweise eine Strahlungsemittierende Schicht. Weiterhin ist zumindest eine der Schichten in der Schichtenfolge 20 empfindlich gegenüber Sauerstoff und/oder Luftfeuchtigkeit.

Auf der Schichtenfolge 20 und dem Substrat 10 sind zwei Doppelschichten 30 angeordnet, so dass die Schichtenfolge 20 zusammen von dem Substrat 10 und den Doppelschichten 30 vollständig umschlossen ist. Die Doppelschichten 30 umfassen jeweils eine erste Schicht 31 und eine zweite Schicht 32, die abwechselnd übereinander angeordnet sind. In Figur 1 sind beispielhaft zwei Doppelschichten 30 gezeigt, die Anzahl der Doppelschichten 30 kann aber auch größer gewählt werden.

Die Doppelschichten 30 können beispielsweise aus der Gasphase auf die Schichtenfolge 20 abgeschieden werden. Dabei kann das Substrat in einem Vakuumrezepienten mit den verdünnten oder unverdünnten Dämpfen der entsprechenden Verbindung für 0,1 min bis 10 min ausgesetzt werden. Der Druck dabei liegt beispielsweise zwischen 10⁻⁸ mbar bis 1000 mbar. Die Temperatur kann in einem Bereich von 20°C bis 300°C, beispielsweise unterhalb von 200°C betragen. Sowohl die erste als auch die zweite Schicht können im gleichen Vakuumrezepienten abgeschieden werden. Wird als Material für die erste Schicht eine Phosphonsäure, Carbonsäure oder eine Sulfonsäuregruppe als erste Endgruppe gewählt, können deren Esther oder andere reaktive Derivate verwendet werden, die leichter verdampfbar sind.

Grundsätzlich kann auf der Schichtenfolge zuerst eine erste Schicht oder zuerst eine zweite Schicht abgeschieden werden. Wird zuerst die erste Schicht abgeschieden, müssen auf der Schichtenfolge Gruppen vorhanden sein, an die die erste Schicht anbinden können. Bei diesen Gruppen kann es sich beispielsweise um Metallgruppen handeln. Die äußere Schicht der Verkapselung kann ebenfalls eine erste Schicht oder eine zweite Schicht sein. Ist die äußere Schicht eine erste Schicht kann diese beispielsweise auch als Haftvermittler für weitere aufzubringende Elemente oder Schichten dienen. In Figur 1 ist beispielhaft eine erste Schicht 31 auf der Schichtenfolge aufgebracht und die Verkapselung schließt mit einer zweiten Schicht 32 ab.

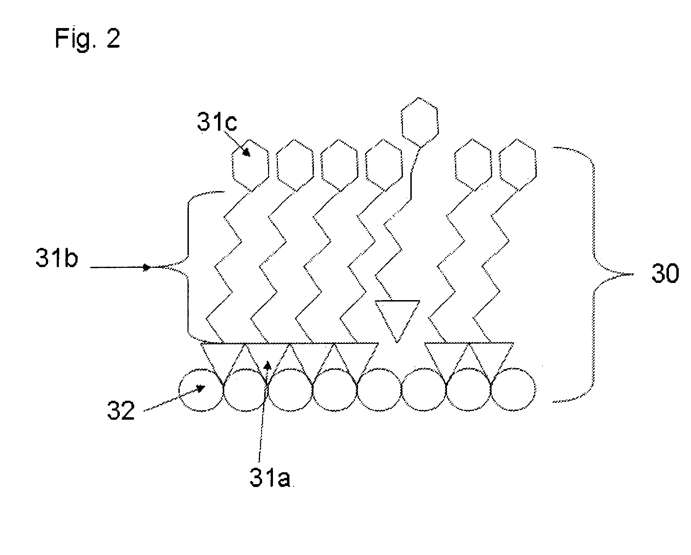

Figur 2 zeigt die schematische Seitenansicht einer Doppelschicht 30. Die erste Schicht 31 und die zweite Schicht 32 wird hier vergrößert dargestellt als eine Zusammensetzung aus schematisch dargestellten Molekülen. Als Materialien dafür können die oben beschriebenen Materialien ausgewählt werden.

Die erste Schicht 31 umfasst ein Material, das eine erste Endgruppe 31a, eine Mittelgruppe 31b und eine zweite Endgruppe 31c umfasst. Die erste Endgruppe 31a kann mit der zweiten Schicht 32 eine chemische Bindung, eine Komplexbindung oder eine Van-der-Waals-Wechselwirkung ausbilden. Damit sind erste und zweite Schicht 31 und 32 dicht miteinander verbunden. Die zweite Endgruppe 31c kann mit einer darauf folgenden zweiten Schicht 32 einer weiteren Doppelschicht 30 ebenso eine Bindung eingehen. Die zweiten Endgruppen 31c können weiterhin untereinander Wechselwirkungen ausbilden, so dass die zweite Schicht dicht ausgebildet wird. Auch die Mittelgruppe 31b kann so ausgebildet sein, dass sie untereinander zwischen den einzelnen Molekülen Wechselwirkungen ausbilden kann. Die linearen Moleküle der ersten Schicht 31 sind in einer zweidimensionalen Ordnung auf der zweiten Schicht 32 angeordnet. Dadurch wird eine insgesamt dichte Doppelschicht 30 ausgebildet.

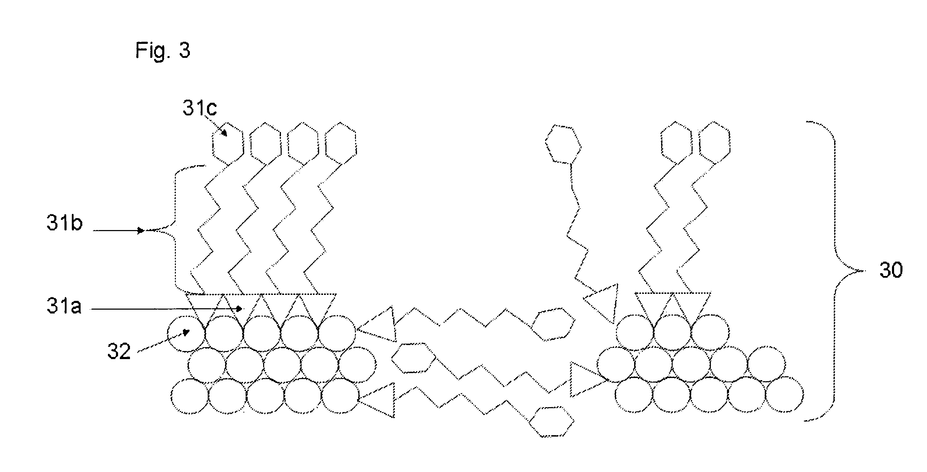

Die Figur 3 zeigt eine weitere Variante einer schematischen Seitenansicht einer Doppelschicht 30. Hier liegt in der zweiten Schicht 32, beispielsweise einer Metallschicht, eine Fehlstelle, beispielsweise ein Pinhole, vor. Diese Fehlstelle wird dadurch gefüllt, dass lineare Moleküle der ersten Schicht 31 zwischen den Teilbereichen der zweiten Schicht 32 angeordnet werden und somit die zweite Schicht 32 abdichten. Damit können Fehler, die bei der Herstellung einer zweiten Schicht 32 auftreten können, durch das Aufbringen der ersten Schicht behoben werden. Dieser Verschlussmechanismus funktioniert für Fehlstellen in der zweiten Schicht, die kleiner als 10 nm sind besonders gut. Bei größeren Pinholes ist die Abscheidung von mehreren Doppelschichten notwendig.

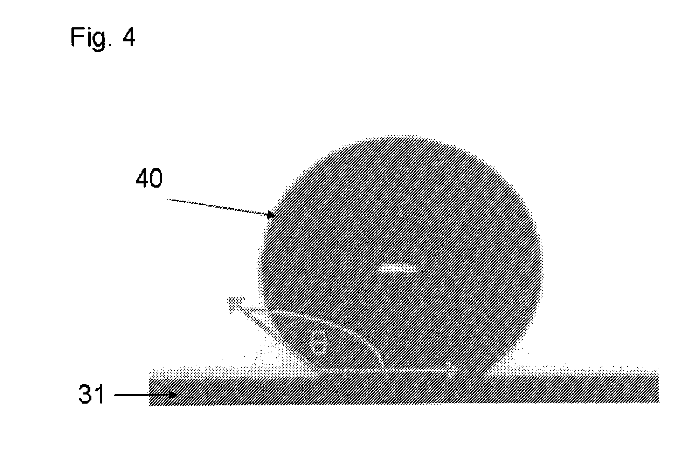

Figur 4 zeigt eine Aufnahme eines Wassertropfens 40 auf der Oberfläche einer ersten Schicht 31. Man sieht, dass der Wassertropfen 40 einen großen Kontaktwinkel Θ zu der ersten Schicht 31 ausbildet. Dies zeigt die starke hydrophobe Eigenschaft der Oberfläche ersten Schicht, was die gute abschirmende Eigenschaft der Doppelschicht 30, die die erste Schicht umfasst, bewirkt.

Für diese Aufnahme wurde ein Substrat aus AlMg₃ mit einer Größe von 15 mm x 25 mm und einer Dicke von 0,5 mm mit N-Methylpyrrolidon gereinigt, danach mit Aceton und Isopropanol entfettet. In einer wässrigen Lösung von Natriumhydrogencarbonat wurden die nativen Oxidschichten, die durch Selbstpassivierung entstehen, bei einem Strom von 150 mA bei 8 bis 10 V durch Schalten des Substrats als Kathode, also durch Wählen einer reduktiven Reinigungsmethode entfernt. Anschließend wurde das Substrat in eine Lösung von Octadecylphosphonsäure (100 mg) in Isopropanol (100 ml) für 30 Minuten eingetaucht. Nach Spülen mit Isopropanol und anschließendem Trocknen im Stickstoffstrom ist die Oberfläche versiegelt mit einer Monolage von Octadecylphosphonsäure. Der Wassertropfen 40 auf der derart behandelten Oberfläche zeigt einen Kontaktwinkel im Bereich von 120°.

Das oben gezeigte Beispiel kann auch mit anderen Aluminiumlegierungen oder reinem Aluminium durchgeführt werden. Anstelle von Aluminiumlegierungen können auch Kupfer, Nickel oder Titan in analoger Weise beschichtet werden. Anstelle der Octadecylphosphonsäure können auch Hexylphosphonsäure oder Decylphosphonsäure verwendet werden. Anstelle der Phosphonsäure als erste Endgruppe kann auch eine Trichlorosilylgruppe verwendet werden. Dabei wird wasserfreies Toluol als Lösungsmittel verwendet und in einer Inertatmosphäre, beispielsweise Stickstoff oder Argon, gearbeitet.

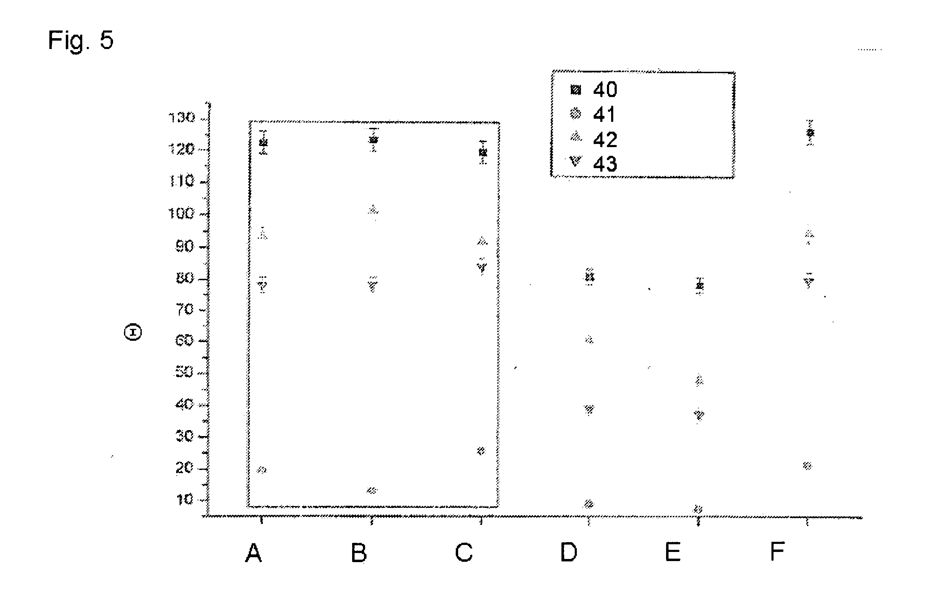

Für die oben genannten Beispiele zeigt Figur 5 eine Zusammenstellung der gemessenen Kontaktwinkel Θ auf den jeweiligen Oberflächen. Als zweite Schicht wurde jeweils AlMg₃ verwendet. Die Länge der Mittelgruppen der linearen Moleküle in der ersten Schicht beträgt 16 bis 18 Kohlenstoffatome, also Hexyl, Decyl oder Octadecyl. Als erste Endgruppe werden Phosphonsäure- oder Trichlorosilylgruppen verwendet. Zur Messung des Kontaktwinkels Θ werden die Medien Wasser 40, Hexadecan 41, Ethylenglykol 42 oder Dimethylsulfoxid (DMSO) 43 verwendet. Die Materialien der ersten Schicht sind Hexanphosphonsäure A, Decanphosphonsäure B, Octadecanphosphonsäure C, Hexantrichlorsilan D, Decantrichlorsilan E und Octadecantrichlorsilan F. Der Kontaktwinkel θ ist in Grad angegeben.

Je größer der Kontaktwinkel Θ, desto höher ist die hydrophobe Eigenschaft der Doppelschicht 30. Moleküle mit einem Phosphonsäuremolekül als erste Endgruppe (Endgruppen A, B und C) bilden somit die dichtesten ersten Schichten aus. Im Falle der Trichlorosilylgruppe als erste Endgruppe (Endgruppen D, E und F) liefert Octadecyltrichlorosilan als das längste Molekül nur wenig kleinere Kontaktwinkel Θ als die Moleküle mit Phosphonsäure als erste Endgruppen. Dies lässt den Schluss zu, dass Octadecylphosphonsäure besonders bevorzugte Eigenschaften in einer Doppelschicht 30 zeigt. Die linearen Moleküle mit Trichlorosilylgruppen als erste Endgruppen können ebenso in der Gasphase aufgebracht werden.

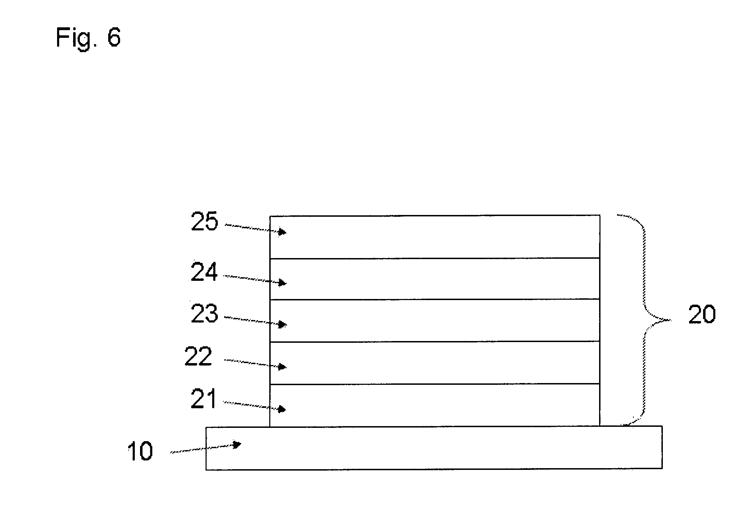

Figur 6 zeigt die schematische Seitenansicht einer Schichtenfolge 20 auf dem Substrat 10, die durch die oben beschriebenen Doppelschichten 30 verkapselt werden kann. Die beispielhafte Schichtenfolge umfasst eine Anode 21, eine Lochtransportschicht 22, eine organische Emissionsschicht 23 als Funktionsschicht, eine Elektronentransportschicht 24 und eine Kathode 25. Es kann auch eine Elektroneninjektionsschicht in der Schichtenfolge aus beispielsweise Ca oder LiF vorhanden sein. Diese kann zwischen der Elektronentransportschicht und der Kathode angeordnet sein (hier nicht gezeigt). Das Substrat 10 kann beispielsweise ein Glassubstrat sein, die Anode kann Indiumzinnoxid enthalten und die Kathode eine Metallkathode sein.

Diese beispielhafte Schichtenfolge 20 kann durch aufeinander folgende Aufdampfprozesse abgeschieden und strukturiert werden, so dass beispielsweise eine OLED hergestellt wird. Bei der Herstellung der OLED wird final eine 120 nm dicke Aluminiumkathode aufgedampft. Für die Abscheidung einer Verkapselung aus Doppelschichten 30 wird das Substrat 10 mit der Schichtenfolge 20 auf dem Substrat 10 in eine Vakuumkammer eingebracht. Dabei wird das Substrat 10 bei 1 mbar auf 80°C aufgeheizt. In die geheizte Vakuumkammer wird über Stickstoff als Trägergas Octadecylphosphonsäurediethylesther für 10 min eingeleitet. Im Anschluss wird die Vakuumkammer wieder auf weniger als 5 x 10⁻⁶ mbar evakuiert, um überschüssigen Octadecylphosphonsäurediethylesther zu entfernen. Nach Hochfahren der Aluminiumquelle werden 100 nm Aluminium durch Verdampfen abgeschieden.

Dieser Abscheidungsprozess der ersten 31 und zweiten Schicht 32 kann beispielsweise weitere viermal wiederholt werden. Die Abscheidung der Doppelschicht 30 kann in der gleichen Vakuumkammer wie die Abscheidung der Aluminiumkathode erfolgen. Die Abscheidung des Octadecylphosphonsäurediethylesther erfolgt bei Raumtemperatur und die Abscheidezeit kann auf 2 min reduziert werden. Weiterhin kann der Octadecylphosphonsäuredimethylesther aus einer separaten Quelle verdampft werden.

Anstelle von reinem Aluminium kann weiterhin die Legierung AlMg₃ aufgedampft werden. Anstelle eines Dampfprozesses werden Sputterprozesse verwendet. Die zweite Schicht in der Doppelschicht 30 kann als Ca-Schicht ausgeführt werden.

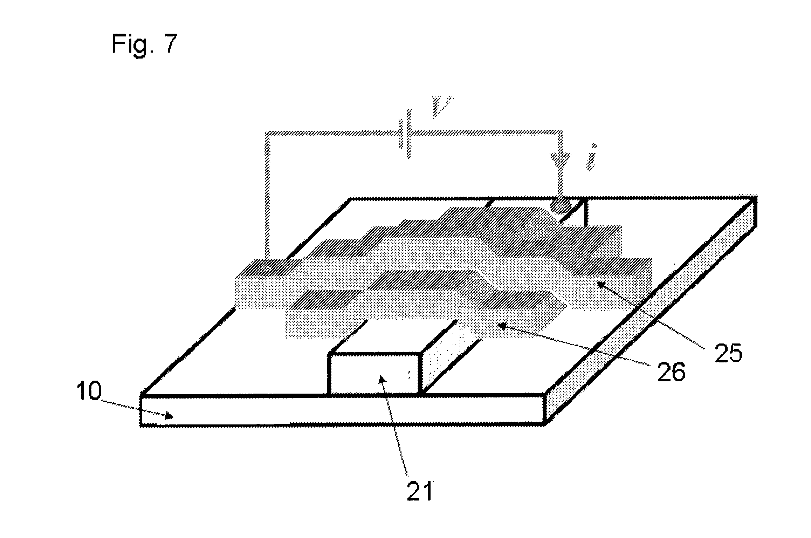

Figur 7 zeigt die schematische Seitenansicht eines weiteren Bauelements. Hier ist auf dem Substrat 10 eine Anode 21, eine organische Schicht 26 und eine Kathode 25 in strukturierter Weise aufgebracht. Beispielhaft ist hier auch gezeigt, wie eine Spannung V angelegt werden muss, um das Bauelement zu betreiben. So wird an die Anode 21 und die Kathode 25 eine Spannung V angelegt, so dass der Strom i fließt. Dieses Bauelement kann beispielsweise eine OMR-Schichtenfolge sein.

Diese Schichtenfolge kann durch aufeinander folgende Aufdampfprozesse auf dem Substrat 10 abgeschieden oder strukturiert werden und final eine 20 nm bis 2 µm, beispielsweise eine 120 nm dicke Aluminiumkathode aufgedampft werden. Die Verkapselung der Schichtenfolge erfolgt analog zu der Verkapselung, wie sie bezüglich der Schichtenfolge der Figur 6 erläutert wurde.

Die in den Figuren gezeigten Ausführungsformen können im Rahmen der Ansprüche beliebig variiert werden. Es ist weiterhin zu berücksichtigen, dass sich die Erfindung nicht auf die Beispiele beschränkt, sondern weitere hier nicht aufgeführte Ausgestaltungen zulässt.

## Patentansprüche

1. Elektronisches Bauelement aufweisend
- ein Substrat,
- eine Schichtenfolge, die zumindest eine Funktionsschicht umfasst, auf dem Substrat, und
- eine Verkapselung, die auf der Schichtenfolge und dem Substrat angeordnet ist und zusammen mit dem Substrat die Schichtenfolge vollständig umschließt, wobei
- die Verkapselung zumindest zwei Doppelschichten aufweist,
- eine Doppelschicht eine erste Schicht und eine zweite Schicht aufweist, und
- die erste Schicht eine organische monomolekulare Schicht mit einer zweidimensionalen Ordnung ist.

2. Elektronisches Bauelement nach Anspruch 1, wobei die erste Schicht lineare Moleküle mit einer Länge, die aus dem Bereich 0,5 nm bis 5 nm ausgewählt ist, umfasst und eine Dicke aufweist, die der Länge der linearen Moleküle entspricht.

3. Elektronisches Bauelement nach dem vorhergehenden Anspruch, wobei die linearen Moleküle eine erste Endgruppe, eine Mittelgruppe und eine zweite Endgruppe umfasst.

4. Elektronisches Bauelement nach dem vorhergehenden Anspruch, wobei die Mittelgruppe aus einer Gruppe ausgewählt ist, die lineare Alkyle, lineare fluorierte Alkyle, Polyethylenglykol und Polyethylendiamin umfasst.

5. Elektronisches Bauelement nach einem der Ansprüche 3 oder 4, wobei die erste Endgruppe aus einer Gruppe ausgewählt ist, die Hydroxamsäuren, Oxime, Isonitrile, Phosphine, R₁-Si(R₂) - R₃, O=C-R₄, O=P(R₅)-R₆ und O=S(R₇)=O umfasst, wobei
- R₁, R₂, R₃ - unabhängig voneinander - ausgewählt sind aus H, Cl, Br, I, OH, 0-Alkylgruppen, Benzylgruppen und ungesättigten Alkenylgruppen, wobei mindestens eines aus R₁, R₂ und R₃ nicht H ist,
- R₄ ausgewählt ist aus H, Cl, Br, I, OH, OSiR₁R₂R₃, 0-Aklkylgruppen, Benzylgruppen und ungesättigten Alkenylgruppen,
- R₅ und R₆ - unabhängig voneinander - ausgewählt sind aus H, Cl, Br, I, OH, O-Alkylgruppen, Benzylgruppen und ungesättigten Alkenylgruppen,
- R₇ ausgewählt ist aus Cl, Br, I, OH, O-Alkylgruppen, Benzylgruppen und ungesättigten Alkenylgruppen.

6. Elektronisches Bauelement nach einem der Ansprüche 3 bis 5, wobei die zweite Endgruppe ausgewählt ist aus einer Gruppe, die die erste Endgruppe, unsubstituierte Arylgruppen, substituierte Arylgruppen, substituierte Aromaten, unsubstituierte Aromaten, substituierte Heteroaromaten und unsubstituierte Heteroaromaten umfasst.

7. Elektronisches Bauelement nach einem der vorhergehenden Ansprüche, wobei die zweite Schicht ein Material aufweist, das aus einer Gruppe ausgewählt ist, die Metalle, Metalllegierungen, Metalloxide und Polymere umfasst.

8. Elektronisches Bauelement nach einem der vorhergehenden Ansprüche, wobei die zweite Schicht eine Dicke aufweist, die aus dem Bereich 5 nm bis 1 µm ausgewählt ist.

9. Elektronisches Bauelement nach einem der Ansprüche 3 bis 8, wobei zwischen der zweiten Schicht und ersten Endgruppe und/oder zwischen der zweiten Schicht und der zweiten Endgruppe chemische Bindungen und/oder Komplexbindungen und/oder Van-der-Waals-Wechselwirkungen vorhanden sind.

10. Elektronisches Bauelement nach einem der vorhergehenden Ansprüche, wobei die Verkapselung zumindest eine dritte Schicht aufweist, die Wasser- und Sauerstoffmoleküle bindet.

11. Elektronisches Bauelement nach einem der vorhergehenden Ansprüche, wobei die Schichtenfolge ausgewählt ist aus einer Gruppe, die organische Leuchtdioden, organische magnetoresistive Bauelemente, anorganische magnetoresistive Bauelemente, elektrochrome Anzeigeelemente, organische Solarzellen, anorganische Solarzellen, organische Photodioden, anorganische Photodioden, organische Sensoren, anorganische Sensoren, und Oberflächenwellenfilter umfasst.

12. Verfahren zur Herstellung eines elektronischen Bauelements mit den Verfahrensschritten
A) Anordnen einer Schichtenfolge, die zumindest eine Funktionsschicht umfasst, auf einem Substrat,
B) Anordnen einer Verkapselung mit zumindest zwei Doppelschichten auf dem Substrat und der Schichtenfolge, so dass die Schichtenfolge von dem Substrat und der Verkapselung vollständig umschlossen ist, wobei der Verfahrensschritt B) die Verfahrensschritte
B1) Aufbringen einer ersten Schicht und
B2) Aufbringen einer zweiten Schicht, wobei als erste Schicht eine organische monomolekulare Schicht mit einer zweidimensionalen Ordnung hergestellt wird,
umfasst, und die Verfahrensschritte B1) und B2) mindestens zweimal abwechselnd wiederholt werden.

13. Verfahren nach dem vorhergehenden Anspruch, wobei im Verfahrensschritt B1) ein Material für die erste Schicht aus der Gasphase oder aus einer Lösung aufgebracht wird.

14. Verfahren nach dem vorhergehenden Anspruch, wobei im Verfahrensschritt B2) ein Material für die zweite Schicht mit einer Methode aufgebracht wird, die aus einer Gruppe ausgewählt ist, die Aufdampfen, Sputtern, Drucken und stromlose Metallisierung umfasst.

15. Verfahren nach dem vorhergehenden Anspruch, wobei im Verfahrensschritt B2) zwischen der ersten Schicht und der zweiten Schicht eine chemische Bindungen und/oder eine Komplexbindung und/oder eine Van-der-Waals-Wechselwirkung gebildet wird.

## Claims

1. Electronic component having
- a substrate,
- a layer sequence comprising at least one functional layer on the substrate, and
- an encapsulation which is arranged on the layer sequence and the substrate and, together with the substrate, completely surrounds the layer sequence, wherein
- the encapsulation has at least two double layers,
- one double layer has a first layer and a second layer, and
- the first layer is an organic monomolecular layer with two-dimensional order.

2. Electronic component according to Claim 1, wherein the first layer comprises linear molecules having a length selected from the range of 0.5 nm to 5 nm and has a thickness corresponding to the length of the linear molecules.

3. Electronic component according to the preceding claim, wherein the linear molecules comprise a first end group, a middle group and a second end group.

4. Electronic component according to the preceding claim, wherein the middle group is selected from a group comprising linear alkyls, linear fluorinated alkyls, polyethylene glycol and polyethylenediamine.

5. Electronic component according to either of Claims 3 and 4, wherein the first end group is selected from a group comprising hydroxamic acids, oximes, isonitriles, phosphines, R₁-Si(R₂)-R₃, O=C-R₄, O=P(R₅)-R₆ and O=S(R₇)=O, where
- R₁, R₂, R₃ - each independently - are selected from H, Cl, Br, I, OH, O-alkyl groups, benzyl groups and unsaturated alkenyl groups, where at least one of R₁, R₂ and R₃ is not H,
- R₄ is selected from H, Cl, Br, I, OH, OSiR₁R₂R₃, O-alkyl groups, benzyl groups and unsaturated alkenyl groups,
- R₅ and R₆ - each independently - are selected from H, Cl, Br, I, OH, O-alkyl groups, benzyl groups and unsaturated alkenyl groups,
- R₇ is selected from Cl, Br, I, OH, O-alkyl groups, benzyl groups and unsaturated alkenyl groups.

6. Electronic component according to any of Claims 3 to 5, wherein the second end group is selected from a group comprising the first end group, unsubstituted aryl groups, substituted aryl groups, substituted aromatics, unsubstituted aromatics, substituted heteroaromatics and unsubstituted heteroaromatics.

7. Electronic component according to any of the preceding claims, wherein the second layer comprises a material selected from a group comprising metals, metal alloys, metal oxides and polymers.

8. Electronic component according to any of the preceding claims, wherein the second layer has a thickness selected from the range of 5 nm to 1 µm.

9. Electronic component according to any of Claims 3 to 8, wherein chemical bonds and/or complex bonds and/or van der Waals interactions are present between the second layer and first end group and/or between the second layer and the second end group.

10. Electronic component according to any of the preceding claims, wherein the encapsulation has at least one third layer which binds water and oxygen molecules.

11. Electronic component according to any of the preceding claims, wherein the layer sequence is selected from a group comprising organic light-emitting diodes, organic magnetoresistive components, inorganic magnetoresistive components, electrochromic display elements, organic solar cells, inorganic solar cells, organic photodiodes, inorganic photodiodes, organic sensors, inorganic sensors and surface wave filters.

12. Process for producing an electronic component, having the process steps of
A) arranging a layer sequence comprising at least one functional layer on a substrate,
B) arranging an encapsulation having at least two double layers on the substrate and the layer sequence, such that the layer sequence is fully surrounded by the substrate and the encapsulation, process step B) comprising the process steps of
B1) applying a first layer and
B2) applying a second layer, the first layer produced being an organic monomolecular layer with two-dimensional order,
and process steps B1) and B2) are repeated at least twice in alternation.

13. Process according to the preceding claim, wherein a material for the first layer is applied from the gas phase or from a solution in process step B1).

14. Process according to the preceding claim, wherein a material for the second layer is applied in process step B2) by a method selected from a group comprising vapour deposition, sputtering, printing and electroless metallization.

15. Process according to the preceding claim, wherein a chemical bond and/or a complex bond and/or a van der Waals interaction is formed in process step B2) between the first layer and the second layer.

## Revendications

1. Composant électronique, présentant
- un substrat,
- une succession de couches, qui comprend au moins une couche fonctionnelle, sur le substrat et
- une encapsulation, qui est disposée sur la succession de couches et le substrat et qui entoure complètement, ensemble avec le substrat, la succession de couches,
- l'encapsulation présentant au moins deux doubles couches,
- une double couche présentant une première couche et une deuxième couche, et
- la première couche étant une couche organique monomoléculaire d'ordre bidimensionnel.

2. Composant électronique selon la revendication 1, la première couche comprenant des molécules linéaires d'une longueur choisie dans la plage de 0,5 nm à 5 nm, et présentant une épaisseur qui correspond à la longueur des molécules linéaires.

3. Composant électronique selon la revendication précédente, les molécules linéaires comprenant un premier groupe terminal, un groupe central et un deuxième groupe terminal.

4. Composant électronique selon la revendication précédente, le groupe central étant choisi dans un groupe comprenant les alkyles linéaires, les alkyles linéaires fluorés, le polyéthylèneglycol et la polyéthylènediamine.

5. Composant électronique selon l'une quelconque des revendications 3 ou 4, le premier groupe terminal étant choisi dans un groupe qui comprend les acides hydroxamiques, les oximes, les isonitriles, les phosphines, R₁-Si(R₂)-R₃, O=C-R₄, O=P(R₅)-R₆ et O=S(R₇)=O, où
- R₁, R₂, R₃ - indépendamment les uns des autres - sont choisis parmi H, Cl, Br, I, OH, les groupes O-alkyle, les groupes benzyle et les groupes alcényle insaturés, au moins un parmi R₁, R₂ et R₃ ne représentant pas H,
- R₄ est choisi parmi H, Cl, Br, I, OH, OSiR₁R₂R₃, les groupes O-alkyle, les groupes benzyle et les groupes alcényle insaturés,
- R₅ et R₆ - indépendamment l'un de l'autre - sont choisis parmi H, Cl, Br, I, OH, les groupes O-alkyle, les groupes benzyle et les groupes alcényle insaturés,
- R₇ est choisi parmi Cl, Br, I, OH, les groupes O-alkyle, les groupes benzyle et les groupes alcényle insaturés.

6. Composant électronique selon l'une quelconque des revendications 3 à 5, le deuxième groupe terminal étant choisi dans un groupe qui comprend le premier groupe terminal, les groupes aryle non substitués, les groupes aryle substitués, les aromatiques substitués, les aromatiques non substitués, les hétéroaromatiques substitués et les hétéroaromatiques non substitués.

7. Composant électronique selon l'une quelconque des revendications précédentes, la deuxième couche présentant un matériau qui est choisi dans un groupe comprenant les métaux, les alliages métalliques, les oxydes métalliques et les polymères.

8. Composant électronique selon l'une quelconque des revendications précédentes, la deuxième couche présentant une épaisseur qui est choisie dans la plage de 5 nm à 1 µm.

9. Composant électronique selon l'une quelconque des revendications 3 à 8, des liaisons chimiques et/ou des liaisons complexes et/ou des interactions de Van-der-Waal existant entre la deuxième couche et le premier groupe terminal et/ou entre la deuxième couche et le deuxième groupe terminal.

10. Composant électronique selon l'une quelconque des revendications précédentes, l'encapsulation présentant au moins une troisième couche, qui lie les molécules d'eau et d'oxygène.

11. Composant électronique selon l'une quelconque des revendications précédentes, la succession des couches étant choisie dans un groupe comprenant les diodes électroluminescentes, les composants organiques magnétorésistants, les composants inorganiques magnétorésistants, les éléments d'affichage électrochromes, les cellules solaires organiques, les cellules solaires inorganiques, les photodiodes organiques, les photodiodes inorganiques, les capteurs organiques, les capteurs inorganiques et les filtres à ondes acoustiques de surface.

12. Procédé pour la fabrication d'un composant électronique, présentant les étapes de procédé
A) disposition d'une succession de couches, qui comprend au moins une couche fonctionnelle, sur un substrat
B) disposition d'une encapsulation présentant au moins deux doubles couches sur le substrat et la succession de couche, de manière telle que la succession de couches est entourée complètement par le substrat et l'encapsulation, l'étape de procédé B) comprenant les étapes de procédé
B1) application d'une première couche et
B2) application d'une deuxième couche, en produisant comme première couche une couche organique monomoléculaire d'ordre bidimensionnel,
et les étapes de procédé B1) et B2) étant répétées au moins deux fois en alternance.

13. Procédé selon la revendication précédente, un matériau pour la première couche étant appliqué dans l'étape B1) à partir de la phase gazeuse ou à partir d'une solution.

14. Procédé selon la revendication précédente, un matériau pour la deuxième couche étant appliqué dans l'étape de procédé B2) par un procédé qui est choisi dans un groupe comprenant la vaporisation, la pulvérisation, l'impression et la métallisation sans courant.

15. Procédé selon la revendication précédente, une liaison chimique et/ou une liaison complexe et/ou une interaction de Van-der-Waals étant formée entre la première couche et la deuxième couche dans l'étape de procédé B2).
